# EUROPEAN PATENT SPECIFICATION

(11) **EP 1 668 713 B1**
(45) Date of publication and mention of the grant of the patent: **21.02.2007**
(21) Application number: 04769347.8
(22) Date of filing: 10.09.2004
(51) Int. Cl.: H01L 39/24

(54) **A METHOD FOR MAKING BIAXIALLY TEXTURED LAYERS ON NON-TEXTURED SUBSTRATES, IN PARTICULAR FOR MAKING INTERMEDIATE BUFFER LAYERS IN SUPERCONDUCTIVE COMPOSITE TAPES**
VERFAHREN ZUR HERSTELLUNG BIAXIAL TEXTURIERTER SCHICHTEN AUF NICHTTEXTURIERTEN SUBSTRATEN, INSBESONDERE ZUR HERSTELLUNG VON ZWISCHEN-PUFFERSCHICHTEN IN BÄNDERN AUS SUPRALEITFÄHIGEM VERBUNDMATERIAL
PROCEDE DE FORMATION DE COUCHES A TEXTURE BIAXIALE SUR DES SUBSTRATS NON-TEXTURES, EN PARTICULIER POUR LA FORMATION DE COUCHES BARRIERE INTERMEDIAIRES DANS DES BANDES EN COMPOSITES SUPRACONDUCTRICES

(30) Priority: 11.09.2003 IT TO20030693
(43) Date of publication of application: 14.06.2006
(73) Proprietor: EDISON S.p.A., 20121 Milano (IT)
(72) Inventor: BALDINI, Alberto, I-50137 Firenze (IT); GAUZZI, Andrea, I-43100 Parma (IT); ZANNELLA, Sergio, I-22066 Mariano Comense (IT)
(74) Representative: Jorio, Paolo
(86) International application number: PCT/IB2004/002955
(87) International publication number: WO 2005/024964

(56) References cited:
- WO-A-03/067672
- US-A1- 2001 007 707
- US-A1- 2003 144 150
- US-B1- 6 190 752
- WATANABE T ET AL: "Progress and future prospects of research and development on coated conductors in Japan" IEEE TRANSACTIONS ON APPLIED SUPERCONDUCTIVITY IEEE USA, vol. 13, no. 2, June 2003 (2003-06), pages 2445-2451, XP002344052 ISSN: 1051-8223

## Description

### TECHNICAL FIELD

The present invention relates to a method for making biaxially textured layers on non-textured substrates, in particular for making intermediate buffer layers in superconductive composite tapes.

### BACKGROUND ART

It is of considerable industrial interest the possibility of large-scale production of high-critical-temperature superconductive films, of the YBCO or REBCO types, deposited on flexible metallic tapes to obtain the so-called "coated conductors", or superconductive composite tapes.

It is known that to obtain the above products it is possible to use two types of metallic substrates, namely, substrates with in-plane biaxial texture and non-textured substrates.

Substrates with in-plane biaxial texture guarantee excellent superconductive properties thanks to the cubic texture obtained via an appropriate process of rolling, followed by high-temperature re-crystallization. The critical current density (jc) of the superconductive layer of YBCO is, in this case, maximized thanks to the biaxial texture induced by the substrate both in the buffer layer (which is made, for example, of MgO, CeO₂, or the like) and in the superconductive layer made of YBCO or REBCO.

Disadvantages of textured substrates are, however, the as yet relatively poor commercial availability, the relatively modest mechanical properties, and the magnetic properties, which entail leakages during a.c. operation.

Instead, non-textured metallic substrates, which are typically made of alloys such as Hastelloy and other non-magnetic steels, present good mechanical properties, are inexpensive, and are not magnetic.

Since these substrates cannot be textured, it is, however, necessary to induce an oriented growth in the first buffer layer (i.e., the one deposited directly on the substrate) via particular processes of deposition with assisted orientation, such as inclined-substrate deposition (ISD, which envisages inclining the substrate with respect to the direction of evaporation), or ion-beam-assisted deposition (IBAD, in which the oriented growth of the layer is favoured via an ion beam oriented directly on the layer). Both of these techniques, and above all IBAD, are, however, relatively complex and costly, since they involve specific constructional and process solutions. The ISD technique is then characterized by a superconductive performance that is decidedly lower than that obtained on textured substrates.

US 6,190,752 B discloses ion-beam-assisted deposition of a layer material on a non-textured substrate having a surface roughness of less than 10 nm.

### DISCLOSURE OF INVENTION

It is an object of the present invention to provide a method that allows the above-referred drawbacks of the known art to be overcome. In particular, it is an object of the invention to provide a method that is of simple and economically advantageous embodiment and that enables, starting from non-textured substrates, high-critical-temperature superconductive tapes having good superconductive properties to be made.

### BEST MODE FOR CARRYING OUT THE INVENTION

In accordance with the above stated objects, the present invention relates to a method for making biaxially textured layers on non-textured substrates, in particular for making intermediate buffer layers in superconductive composite tapes, said method being characterized by comprising:
- a step of providing a non-textured substrate with a surface having a roughness of less than approximately 10 nm and preferably less than approximately 5 nm;
- a non-assisted deposition step, in which a deposition material is deposited on said surface with direct evaporation without any concern for the orientation; and
- a step of natural-texture growth of the deposition material on the surface occurring during said non-assisted deposition step to form an oriented layer with biaxial texture.

As is known, by "natural texture" of a layer being formed on a substrate is meant the texture corresponding to the crystallographic direction that minimizes the surface tension at the interface between the substrate and the layer being formed.

The method according to the invention enables deposition of an oriented layer with a good degree of biaxial texture, a layer which can, for example, constitute a buffer layer for a superconductive composite tape, on a non-textured substrate, without requiring complex deposition techniques with assisted orientation, such as ISD and IBAD techniques. Consequently, a layer made of superconductive material subsequently deposited on said oriented layer will in turn be correctly oriented and will possess excellent superconductive properties, which will not be impaired even in part by the preceding fabrication steps.

It has in fact been found that surface finishing (i.e., roughness) of the substrate ensures oriented growth of the layer of deposition material, irrespective of the characteristics of orientation of the substrate itself.

Consequently, a non-textured substrate, provided that it has a surface roughness below a critical value, gives rise to the deposition of an oriented layer with a good biaxial texture.

According to the invention, the deposition step is hence a "non-assisted deposition step", whereby it is meant that, unlike deposition processes with assisted orientation, such as the ISD and IBAD techniques, a deposition step with direct evaporation, in which the oriented growth of the layer that is deposited on the substrate is not induced or assisted either by an inclination of the substrate with respect to the direction of evaporation (as in the case of the ISD technique) or by auxiliary forms of treatment carried out directly on the layer that grows during the deposition step (as in the IBAD technique).

In other words, according to the invention, the non-assisted deposition step is defined by the fact that:
i) the substrate is on average orthogonal to the direction of evaporation, i.e., it is substantially orthogonal, point by point, to the direction of evaporation; and
ii) the deposition step is performed without any auxiliary treatment, in particular ion-radiation treatment, applied directly on the layer that is growing during the deposition step for orienting the growth of the layer.

Preferably, the substrate is made of metallic material, and the method according to the invention comprises a step of lapping of the metallic substrate to provide the surface with the necessary degree of surface finish: the roughness must be less than approximately 10 nm and preferably less than approximately 5 nm.

The lapping step can be performed using any known technique and includes, in particular, one or more mechanical, chemical, and/or electrochemical forms of treatment.

For example, metallic alloys of the Hastelloy type have proven particularly indicated, said alloys, also thanks to their relatively high hardness, enabling an extremely low surface roughness (even less than 2 nm) to be obtained.

It remains understood that other types of substrates can be used, including substrates made of polymeric material. In this case, the surface on which the oriented layer is to be grown can be made with the desired degree of surface finish (i.e., a degree of roughness below the critical value indicated) directly in the step of moulding or forming of the substrate.

The deposition step is carried without any specific concern for determining a specific orientation of the deposition material. In general terms, the deposition step comprises the steps of evaporating precursors of the deposition material to form an evaporation area, and of supporting the substrate within the evaporation area with the surface to be coated exposed to the evaporation area and substantially orthogonal to the direction of evaporation.

Any known technique of evaporation can evidently be employed. The precursors of the deposition material are, for example, contained in crucibles and are evaporated by electrical heating or electron bombardment, or other similar techniques.

The deposition step has to be performed with parameters of deposition rate and of temperature selected in such a way as not to jeopardize but to favour growth in a natural texture of the deposition material. Said parameters will be identified, case by case, according to the deposition material (and to the substrate) .

Preferably, the substrate is a flexible tape-shaped substrate.

The method according to the invention finds, in fact, a preferred application in obtaining superconductive tapes, in particular tapes provided with an YBCO or REBCO superconductive layer, and hence comprises also a step of deposition of a superconductive layer, in particular an YBCO or REBCO layer, on top of the oriented layer of deposition material.

The deposition material is selected so as to present a natural texture that enables textured growth on top of said natural texture of a superconductive layer.

In particular, the deposition material is a dielectric or conductive material, such as MgO or the like, having a natural texture compatible with the textured growth of an YBCO or REBCO superconductive layer.

According to the invention there are consequently used those materials, such as MgO, for which the natural texture is also the one that enables texturing of the layer of YBCO or REBCO.

In the case of MgO, the natural texture is the texture [100], which, as is known, is also the texture that enables the textured growth of YBCO superconductive layers. When, in fact, the buffer layer has the texture [100], the YBCO layer grows with biaxial texture on the buffer layer, without any need to adopt further measures.

The invention is further described in the ensuing non-limiting example of embodiment.

### EXAMPLE

A non-textured metallic substrate in the form of a tape made of Hastelloy was provided.

A surface of the substrate having an initial roughness of approximately 1 µm was mirror-polished through a cycle of lapping until it had a roughness of less than 5 nm. A first lapping step was performed with a felt cloth coated with an abrasive layer of diamond paste with a grain size of 1 µm. A second lapping step was performed using a second cloth soaked in a diluted acidic solution. The surface of the substrate appeared smooth and mirror-polished.

The substrate was sent into a vacuum chamber, in which deposition of a buffer layer of MgO, deposited via evaporation using an electron gun, was carried out. A layer having a thickness of approximately 1 µm was deposited at a deposition rate of 30 nm/min and at a temperature of 200°C. Said layer showed an excellent degree of biaxial texture in the plane according to the crystallographic plane [100] of MgO.

The substrate provided with buffer layer was then coated with a superconductive layer of YBCO, deposited on the buffer layer according to known techniques. The resulting material showed excellent superconductive properties.

## Claims

1. A method for making biaxially textured layers on non-textured substrates, in particular for making intermediate buffer layers in superconductive materials, **characterized by** comprising: a step of providing a non-textured substrate with a surface having a roughness of less than approximately 10 nm; a non-assisted deposition step, in which a deposition material is deposited on said surface by direct evaporation and without any concern for orientation; and a step of natural-texture growth of the deposition material on said surface, occurring during said non-assisted deposition step, to form an oriented layer with biaxial texture.

2. The method according to Claim 1, **characterized in that**, in the deposition step, the substrate is substantially orthogonal to the direction of evaporation, and the deposition step is not assisted by ion-radiation treatment.

3. The method according to Claim 1 or Claim 2, **characterized in that** the substrate is a metallic substrate, and the method comprises a step of lapping of said metallic substrate to provide said surface.

4. The method according to any one of the preceding claims, **characterized in that** the deposition step comprises the steps of evaporating precursors of the deposition material to form an evaporation area, and of supporting the substrate within the evaporation area with said surface exposed to the evaporation area.

5. The method according to any one of the preceding claims, **characterized in that** the deposition material is selected so that it presents a natural texture that enables textured growth of a superconductive layer on top of said natural texture.

6. The method according to any one of the preceding claims, **characterized in that** the deposition material is a dielectric or conductive material, such as MgO or the like, having a natural texture compatible with the textured growth of an YBCO or REBCO superconductive layer.

7. The method according to any one of the preceding claims, **characterized in that** it comprises a step of deposition of a superconductive layer, in particular an YBCO or REBCO layer, above the layer of deposition material.

8. The method according to any one of the preceding claims, **characterized in that** the deposition step is performed with parameters of deposition rate and of temperature selected in such a way as to favour a natural-texture growth of the deposition material to form said oriented layer.

## Patentansprüche

1. Verfahren zum Herstellen biaxial texturierter Schichten auf nicht texturierten Substraten, insbesondere zur Herstellung von Zwischenpufferschichten in supraleitenden Materialien, **dadurch gekennzeichnet, dass** es umfasst: einen Schritt des Vorsehens eines nicht texturierten Substrats mit einer Oberfläche, deren Rauheit geringer als ungefähr 10 nm ist; einem nicht unterstützten Depositionsschritt, bei dem ein Depositionsmaterial durch unmittelbares Verdampfen und ungeachtet der Ausrichtung auf die Oberfläche aufgebracht wird; und einen Schritt des Wachstums einer natürlichen Textur des Depositionsmaterials auf der Oberfläche, der während des nicht unterstützten Depositionsschritts stattfindet, um eine orientierte Schicht mit biaxialer Textur zu bilden.

2. Verfahren nach Anspruch 1, **dadurch gekennzeichnet, dass** das Substrat in dem Depositionsschritt im wesentlichen orthogonal zu der Verdampfungsrichtung angeordnet ist und der Depositionsschritt nicht durch Ionenstrahlungsbehandlung unterstützt wird.

3. Verfahren nach Anspruch 1 oder Anspruch 2, **dadurch gekennzeichnet, dass** das Substrat ein metallisches Substrat ist und das Verfahren den Schritt des Läppens des metallischen Substrats aufweist, um die genannte Oberfläche zu bilden.

4. Verfahren nach einem der vorhergehenden Ansprüche, **dadurch gekennzeichnet, dass** der Depositionsschritt die Schritte des Verdampfens von Präkursoren des Depositionsmaterials zum Bilden eines Verdampfungsbereichs und des Stützens des Substrats in dem Verdampfungsbereich mit dem Verdampfungsbereich ausgesetzter Oberfläche umfasst.

5. Verfahren nach einem der vorhergehenden Ansprüche, **dadurch gekennzeichnet, dass** das Depositionsmaterial derart gewählt ist, dass es eine natürliche Textur aufweist, welche das texturierte Wachsen einer supraleitenden Schicht auf der natürlichen Textur ermöglicht.

6. Verfahren nach einem der vorhergehenden Ansprüche, **dadurch gekennzeichnet, dass** das Depositionsmaterial ein dielektrisches oder leitfähiges Material ist, wie MgO oder dergleichen, das eine natürliche Textur aufweist, die mit dem texturierten Wachsen einer supraleitenden YBCO- oder REBCO-Schicht kompatibel ist.

7. Verfahren nach einem der vorhergehenden Ansprüche, **dadurch gekennzeichnet, dass** es den Schritt des Deponierens einer supraleitenden Schicht, insbesondere einer YBCO- oder REBCO-Schicht, über der Depositionsmaterialschicht umfasst.

8. Verfahren nach einem der vorhergehenden Ansprüche, **dadurch gekennzeichnet, dass** der Depositionsschritt mit Parametern der Depositionsrate und der Temperatur durchgeführt wird, welche derart gewählt sind, dass sie ein Züchten einer natürlichen Textur des Depositionsmaterials begünstigen, um so die orientierte Schicht zu bilden.

## Revendications

1. Procédé de formation de couches à texture biaxiale sur des substrats non-texturés, en particulier pour la formation de couches de barrière intermédiaires dans des matières supraconductrices, **caractérisé en ce qu'**il comprend : une étape de fourniture d'un substrat non-texturé avec une surface ayant une rugosité inférieure à 10 nm environ ; une étape de dépôt non assisté, dans laquelle une matière de dépôt est déposée sur ladite surface par évaporation directe et sans un quelconque problème d'orientation ; et une étape de croissance de texture naturelle de la matière de dépôt sur ladite surface, se produisant pendant ladite étape de dépôt non assistée, pour former une couche orientée ayant une texture biaxiale.

2. Procédé selon la revendication 1, **caractérisé en ce que**, dans l'étape de dépôt, le substrat est sensiblement orthogonal par rapport à la direction d'évaporation, et l'étape de dépôt est non assistée par le traitement de rayonnement ionique.

3. Procédé selon la revendication 1 ou la revendication 2, **caractérisé en ce que** le substrat est un substrat métallique, et le procédé comprend une étape de recouvrement dudit substrat métallique pour donner ladite surface.

4. Procédé selon l'une quelconque des revendications précédentes, **caractérisé en ce que** l'étape de dépôt comprend les étapes d'évaporation des précurseurs de la matière de dépôt pour former une zone d'évaporation, et de support du substrat à l'intérieur de la zone d'évaporation avec ladite surface exposée à la zone d'évaporation.

5. Procédé selon l'une quelconque des revendications précédentes, **caractérisé en ce que** la matière de dépôt est choisie de sorte à présenter une texture naturelle qui permet la croissance texturée d'une couche supraconductrice au-dessus de ladite texture naturelle.

6. Procédé selon l'une quelconque des revendications précédentes, **caractérisé en ce que** la matière de dépôt est une matière diélectrique ou conductrice, telle que MgO ou similaire, ayant une texture naturelle compatible avec la croissance texturée d'une couche supraconductrice YBCO ou REBCO.

7. Procédé selon l'une quelconque des revendications précédentes, **caractérisé en ce qu'**il comprend une étape de dépôt d'une couche supraconductrice, en particulier une couche YBCO ou REBCO, au-dessus de la couche de matière de dépôt.

8. Procédé selon l'une quelconque des revendications précédentes, **caractérisé en ce que** l'étape de dépôt est effectuée avec les paramètres de vitesse de dépôt et de température choisis de telle manière à favoriser une croissance de texture naturelle de la matière de dépôt pour former ladite couche orientée.
